(19) Europäisches Patentamt
European Patent Office
Office européen des brevets

(11) EP 1 307 786 B1

(12) **EUROPEAN PATENT SPECIFICATION**

(45) Date of publication and mention of the grant of the patent:
**05.05.2010 Bulletin 2010/18**

(21) Application number: **01918830.9**

(22) Date of filing: **19.03.2001**

(51) Int Cl.:
*G03F 7/42* (2006.01) *C11D 7/50* (2006.01)
*C11D 7/26* (2006.01) *C11D 7/32* (2006.01)

(86) International application number:
**PCT/US2001/008772**

(87) International publication number:
**WO 2001/071429 (27.09.2001 Gazette 2001/39)**

# (54) METHOD AND COMPOSITION FOR REMOVING SODIUM-CONTAINING MATERIAL FROM MICROCIRCUIT SUBSTRATES

VERFAHREN UND ZUSAMMENSETZUNG ZUR ENTFERNUNG VON NATRIUM ENTHALTENDEM MATERIAL VON MIKROSCHALTUNGSSUBSTRATEN

PROCEDE ET COMPOSITION PERMETTANT DE RETIRER UN MATERIAU CONTENANT DU SODIUM D'UN SUBSTRAT DE MICROCIRCUIT

(84) Designated Contracting States:
**AT BE CH CY DE DK ES FI FR GB GR IE IT LI LU MC NL PT SE TR**

(30) Priority: **20.03.2000 US 190071 P**

(43) Date of publication of application:
**07.05.2003 Bulletin 2003/19**

(73) Proprietor: **Mallinckrodt Baker, Inc.**
**Phillipsburg, New Jersey 08865 (US)**

(72) Inventor: **SCHWARTZKOPF, George**
**Washington, NJ 07882 (US)**

(74) Representative: **Chettle, Adrian John et al**
**Withers & Rogers LLP**
**Goldings House**
**2 Hays Lane**
**London**
**SE1 2HW (GB)**

(56) References cited:
**WO-A-99/60448** **JP-A- 10 171 130**
**US-A- 5 417 802**

- **[Online] retrieved from CHEMIDPLUS LITE Database accession no. Cyclohexanediamine tetraacetic acid**

EP 1 307 786 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### BACKGROUND OF THE INVENTION

#### Field of the Invention

The present invention is in the field of removing photoresist and other materials from microcircuit substrates in the manufacture of integrated circuits.

#### Description of Background Art

An integral part of microelectronic fabrication is the use of photoresists to transfer an image from a mask or reticle to the desired circuit layer. After the desired image transfer has been achieved, the photoresist is removed by stripping before proceeding to some subsequent process step.

Contamination by mobile ions, especially by sodium ions, is responsible for many failures of integrated circuits, especially during high temperature operation bias burn-in tests. Mobile ion contamination may be introduced at various stages during integrated circuit fabrication.

Those concerned with the development of integrated circuit technology have continuously sought for materials and techniques to reduce mobile ion contamination. In U.S. Patent No. 5,417,802, crown ethers were used to sequester Group I and Group II ions in organic solvents used for photoresist removal.

JP 10 171130 describes a photo-resist removing solution containing an organic amine which maybe 1,2-cyclohexanediamine tetracetic acid.

WO99/60448 relates to silicate containing alkaline compositions for cleaning microelectronic substrates, in particular to aqueous stripping or cleaning compositions for semiconductor wafer substrates comprising one or more metal ion-free bases and the a water-soluble metal ion-free silicate.

### SUMMARY OF INVENTION

In accordance with the present invention, a method and composition are provided as defined in the claims. These may be for stripping sodium-containing material, such as photoresist. The stripping composition comprises 1,2-Diaminocyclohexanetetracarboxylic Acid (CYDTA) in an organic solvent. The method of the invention comprises contacting said substrate with said stripping composition.

### DETAILED DESCRIPTION OF THE INVENT

The organic solvents used in photoresist removal and post-metal etch cleaning are a common source of mobile ion contamination. Typical solvents include blends of primary and secondary amines and other inert solvents such as dimethylsulfoxide and dimethylacetamide. These solvents are usually stored in plastic (for example, high density polypropylene) containers. The manufacture of these plastic containers involves the use of inorganic catalysts, which may contain sodium. Consequently, when the solvents are stored in these plastic containers, sodium can leach into the solvent. The concentration of sodium in the solvent increases with the duration of contact with the plastic.

It has been discovered that 1,2 cyclohexanediaminetetraacetic acid (CYDTA), which coordinates well with sodium ions, inhibits the adsorption of sodium to integrated circuit surfaces. The addition of CYDTA, to organic solvents conventionally used in either photoresist removal or post-metal etch clean-up has been found to significantly reduce the concentration of sodium found on the surface of the resulting cleaned integrated circuits.

Experiments using titanium nitride deposited on silicon substrates and inspected with secondary ion mass spectroscopy (SIMS) indicate that the addition of CYDTA to such conventional organic solvent formulations as ALEG-310®, a registered trademark of Mallinckrodt Baker Incorporated of Phillipsburg, NJ, significantly reduced the surface sodium concentrations of these substrates. Direct comparison to parallel treatments with the previously disclosed crown ethers showed that the present invention resulted in much lower sodium concentrations on the resulting cleaned surfaces.

In a typical application, a patterned photoresist may be removed from etched oxide, metal or semiconductor substrate features using an organic solvent modified by the addition of CYDTA thereby reducing the extent of sodium contamination of the resulting integrated circuit. Alternatively, the photoresist may be partially removed by exposure to an oxygen plasma and the resulting unwanted residues further removed using the present invention.

One embodiment utilizes a stripping solvent, a nucleophilic amine, a non-nitrogen containing weak acid in an amount sufficient to partially neutralize the nucleophilic amine such that the stripping composition has an aqueous pH, when diluted with about 10 parts of water, of 9.6 to 10.9, said weak acid having a pK value in aqueous solution of 2.0 or greater and an equivalent weight of less than 140, and CYDTA, whereby said stripping composition is able to strip

unwanted photoresist or photoresist residues with minimal increases in the surface sodium concentration of the cleaned integrated circuit.

The non-nitrogen containing weak acids that is employed in this invention include organics such as carboxylic acids or phenols as well as salts of inorganic acids such as carbonic or hydrofluoric acid.

By weak acids is meant acids having a strength expressed as a "pK" for the dissociation constant in aqueous solution of at least 2.0 or higher, preferably 2.5 or higher. Particularly useful are weak acids of pK>2.0. The acids have an equivalent weight of less than 140. As examples of such non-nitrogen containing weak acids useful in this invention there may be mentioned, for example, carboxylic acids such as acetic acid, phthalic acid, phenoxyacetic acid, organic acids such as 2-mercaptobenzoic acid, 2-mercaptoethanol, phenols generally having pK in the range of from 9 to 10, such as phenol, 1,3,5-trihydroxybenzene, pyrogallol, resorcinol, 4-tert-butylcatechol and inorganic acids such as carbonic acid, hydrofluoric acid. The amount of weak acid employed in the stripping compositions of this invention is from 0.05% to 25% by weight of said composition and is present in an amount to neutralize 19% to 75% by weight of the amine present in the stripper composition thereby resulting in an aqueous rinse pH for said stripper compositions of from pH 9.6 to 10.9.

Alkaline stripper components that may be used in this invention also cover a wide range of structural types. Their dissociation constants, once again expressed as pK values, range from 9 to 11 for the beta-oxygen or -nitrogen substituted amines to 8.3 for the secondary amine, morpholine and hydroxylamines and hydroxylamine derivatives of somewhat lower pK values. Among the alkaline components that may be used there may be mentioned, nucleophilic amines, preferably for example, 1-amino-2-propanol, 2-(2-aminoethoxy)ethanol, 2-aminoethanol, 2-(2-aminoethylamino) ethanol, 2-(2-aminoethylamino)ethylamine. More important than the actual pK value of an amine is its nucleophilicity which should be high. The amount of amine component employed in the stripping compositions of this invention is from 1% to 50% by weight of said composition.

It is believed that the interaction of these alkaline stripper components with the range of weak acids used in this invention is essentially reversible:

$$\text{alkaline component} + \text{acid} \rightleftharpoons \text{salt-like complex.}$$

Because of the reversibility of this reaction, substantial concentrations of the alkaline component would remain available during the stripping process even though much of the alkaline component has been neutralized from a stoichiometric point of view. This would account for the surprisingly rapid stripping rates that are observed even in the presence of these acids.

The photoresist stripping compositions of this invention comprise an organic solvent system. The organic solvent system is one having a solubility parameter of from 8 to 15, obtained by taking the square root of the sum of the squares of the three Hansen solubility parameters (dispersive, polar and hydrogen bonding). The solvent system may comprise any of a number of individual solvents or a mixture of several different solvents. As example of such solvents there may be mentioned, various pyrrolidinone compounds such as 2-pyrrolidinone, 1-methyl-2-pyrrolidinone, 1-ethyl-2-pyrrolidinone, 1-propyl-2-pyrrolidinone, 1-hydroxyethyl-2-pyrrolidinone, 1-hydroxypropyl-2-pyrrolidinone, and the like, diethylene glycol monoalkyl ethers such as those of the formula $HOCH_2CH_2\text{-O-}CH_2CH_2\text{-O-R}$ where R is an alkyl radical of from 1 to 4 carbon atoms, compounds containing sulfur oxides such as dialkyl sulfones of the formula

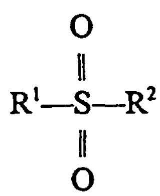

where $R^1$ and $R^2$ are alkyl of 1 to 4 carbon atoms, dimethyl sulfoxide (DMSO), tetrahydrothiophene-1,1-dioxide compounds of the formula

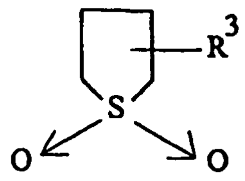

wherein $R^3$ is hydrogen, methyl or ethyl, such as sulfolane, methyl sulfolane and ethyl sulfolane, as well as polyethylene glycols, dimethylacetamide or dimethylformamide. The solvent system portion of the stripper compositions of this invention will comprise from 50% to 98% by weight of the composition, preferably 85% to 98% by weight.

Preferred solvents are N-alkyl-2-pyrrolidinones, such as N-methyl, N-ethyl-, N-propyl-, and N-(2-hydroxyethyl)-, Dimethylsulfoxide, Dimethylacetamide and Dimethylformamide.

Particularly preferred solvents are N-methyl-2-pyrrolidinone and tetrahydrothiophene-1,1-dioxide.

EXAMPLE

One thousand grams of a stripper solvent containing about 50 parts of N-methyl-2-pyrrolidinone, about 10 parts of tetrahydrothiophene-1,1-dioxide, about 25 parts of 2-aminoethanol, about 5 parts of 1,2-dihydroxybenzene, and about 10 parts of water were weighed into a fluoropolymer beaker. The additives, CYDTA or 18-Crown-6, were weighed out and dissolved in the stripper solvent as needed. The solution was then raised to the desired temperature and a titanium nitride (TiN) coated wafer was placed in the solution for twenty minutes, removed and rinsed with DI water and analyzed using SIMS. All experiments were carried out in a class 100 clean room taking extra care to prevent sodium contamination of the wafer.

Three wafers were subjected to the water rinsing and drying step only to establish a baseline sodium value without any stripper solvent treatment. The unmodified stripper solvent was tested at 65°C and 85°C for twenty minutes to determine the relative sodium levels left behind on the TiN surface by this process. Results are shown in Table 1. For the second set of experiments, 0.1 weight percent of 1,2- The Monhydrate of CYDTA was added to the stripper solvent. For the third set of experiments the weight percent of CYDTA Monhydrate was increased to 0.5%. For the fourth set of experiments the weight percent of CYDTA Monhydrate was increased to 0.9%. In the fifth set, 0.1 weight percent of 18-Crown-6 was added to the stripper solvent and tested at 45°C, 65°C and 85°C.

These data (Table 1) clearly show that the addition of CYDTA to the stripper solvent results in much lower sodium surface concentrations than the unmodified solvent. Crown ether addition had no beneficial effect.

Table 1

| Process | Treatment Temperature | Relative Surface Sodium Concentration (using SIMS) |
|---|---|---|
| Water rinse and dry | (untreated) | 0.0052, 0.0046, 0.0051 |
| Stripper solvent only (comparative) | 65°C | 0.16 |
| | 85°C | 0.25 |
| Solvent + 0.1 % CYDTA | 65°C | 0.04 |
| | 85°C | 0.07 |
| Solvent + 0.5% CYDTA | 65°C | 0.02 |
| | 85°C | 0.05 |
| Solvent + 0.9% CYDTA | 65°C | 0.03 |
| | 85°C | 0.04 |
| Solvent + 0.1% 18-Crown-6 (comparative) | 45°C | 0.33 |
| | 65°C | 0.41 |
| | 85°C | 0.45 |

**Claims**

1. A method of inhibiting adsorption of sodium-to integrated circuit surfaces during photoresist removal or post-metal etch cleanup with an organic solvent-containing composition, comprising contacting the surface with an organic solvent-containing composition comprising:

   a) 1,2-cyclohexanediamine tetracetic acid (CYDTA),
   b) a nucleophilic amine present in an amount of from 1 to 50% by weight of the composition,
   c) a non-nitrogen containing weak acid in an amount sufficient to partially neutralize the nucleophilic amine such that the composition has an aqueous pH, when diluted with 10 parts of water, of. 9.6 to 10.9, said weak acid having a pK value in aqueous solution of 2.0 or greater and an equivalent weight of less than 140, and
   d) the solvent is a stripping solvent system having a solubility parameter of from 8 to 15 and is present in an amount of from 50% to 98% by weight of the composition.

2. The method of claim 1, wherein the weak acid is present in the composition in an amount of from 0.05% to 25% by weight of said stripping composition.

3. The method of claim 2, wherein the weak acid has a pK of 2.5 or higher.

4. The method of claim 3 wherein the weak acid is 1,2-dihydroxybenzene.

5. The method of claim 4 wherein the nucleophilic amine is 2-aminoethanol.

6. The method of claim 5 wherein the solvent system comprises N-methyl-2-pyrrolidinone and tetrahydrothiophene-1,1-dioxide and optionally up to 10% water.

7. The method of claim 1 comprising, on a weight basis, from 50% to 98% of N-methyl-2-pyrrolidinone, from I to 20% of tetrahydrothiopliene-1, 1-dioxide, from about 1 to 20% of water, from 1 to 50% of 2-aminoethanol, from 0.05% to 25% of 1,2-dihydroxybenzene and 0.01% to 5% of CYDTA.

8. A composition for inhibiting adsorption of sodium-to integrated circuit surfaces during photoresist removal or post-metal etch cleanup with an organic solvent-containing composition, said organic solvent-containing composition comprising:

   a) CYDTA,
   b) a nucleophilic amine present in an amount of from I to 50% by weight of the composition,
   c) a non-nitrogen containing weak acid in an amount sufficient to partially neutralize the nucleophilic amine such that the composition has an aqueous pH, when diluted with 10 parts of water, of 9.6 to 10.9, said weak acid having a pK value in aqueous solution of 2.0 or greater and an equivalent weight of less than 140, and
   d) the solvent is a stripping solvent system having a solubility parameter of from 8 to 15 and is present in an amount of from 50% to 98% by weight of the composition.

9. The composition of claim 8, wherein the weak acid is present in the composition in an amount of from 0.05% to 25% by weight of said stripping composition.

10. The composition of claim 9, wherein the weak acid has a pK of 2.5 or higher.

11. The composition of claim 10 wherein the weak acid is 1,2-dihydroxybenzene.

12. The composition of claim 11 I wherein the nucleophilic amine is 2-aminoethanol.

13. The composition of claim 12 wherein the solvent system comprises N-methyl-2-pyrrolidinone and tetrahydrothiophene-1,1-dioxide and optionally up to 10% water.

14. The composition of claim 8 comprising, on a weight basis, from 50% to 98% of N-methyl-2-pyrrolidinone, from 1 to 20% of tetrahydrothiophene-1,1-dioxide, from 1 to 20% of water, from 1 to 50% of 2-aminoethanol, from 0.05% to 25% of 1,2-dihydroxybenzene and, 0.01% to 5% of CYDTA.

**Patentansprüche**

1. Verfahren zum Inhibieren von Natriumadsorption an Oberflächen eines integrierten Schaltkreises während einer Fotolackentfernung oder während einer Entschichtung nach einer Metallätzung mit einer organisches Lösungsmittel enthaltenden Zusammensetzung, umfassend In-Kontakt-bringen der Oberfläche mit einer organisches Lösungsmittel enthaltenden Zusammensetzung, umfassend:

   a) 1,2-Cycohexandiamin-tetraessigsäure (CYDTA),
   b) ein nukleophiles Amin, das in einer Menge von 1 % bis 50% bezogen auf das Gewicht der Zusammensetzung vorhanden ist,
   c) eine stickstofffreie schwache Säure in einer Menge, die ausreichend ist, das nukleophile Amin zum Teil zu neutralisieren, so dass die Zusammensetzung, wenn sie mit 10 Teilen Wasser verdünnt wird, einen wässrigen pH von 9,6 bis 10,9 hat, wobei die schwache Säure in wässriger Lösung einen pK-Wert von 2,0 oder größer und eine Äquivalentmasse von weniger als 140 hat, und
   d) das Lösungsmittel ein Stripplösungsmittelsystem ist, das einen Löslichkeitsparameter von 8 bis 15 hat und in einer Menge von 50% bis 98% bezogen auf das Gewicht der Zusammensetzung vorhanden ist.

2. Verfahren nach Anspruch 1, wobei die schwache Säure in der Zusammensetzung in einer Menge von 0,05% bis 25% bezogen auf das Gewicht der Strippzusammensetzung vorhanden ist.

3. Verfahren nach Anspruch 2, wobei die schwache Säure einen pK von 2,5 oder höher hat.

4. Verfahren nach Anspruch 3, wobei die schwache Säure 1,2-Dihydroxybenzol ist.

5. Verfahren nach Anspruch 4, wobei das nukleophile Amin 2-Aminoethanol ist.

6. Verfahren nach Anspruch 5, wobei das Lösungsmittelsystem N-Methyl-2-pyrrolidinon und Tetrahydrothiophen-1,1-dioxid und gegebenenfalls bis zu 10% Wasser umfasst.

7. Verfahren nach Anspruch 1, umfassend, auf Gewichtsbasis, 50% bis 98% N-Methyl-2-pyrrolidinon, 1% bis 20% Tetrahydrothiophen-1,1-dioxid, ungefähr 1% bis 20% Wasser, 1% bis 50% 2-Aminoethanol, 0,05% bis 25% 1,2-Dihydroxybenzol und 0,01 % bis 5% CYDTA.

8. Zusammensetzung zum Inhibieren von Natriumadsorption an Oberflächen eines integrierten Schaltkreises während einer Fotolackentfernung oder während einer Entschichtung nach einer Metallätzung mit einer organisches Lösungsmittel enthaltenden Zusammensetzung, umfassend In-Kontakt-bringen der Oberfläche mit einer organisches Lösungsmittel enthaltenden Zusammensetzung, umfassend:

   a) CYDTA,
   b) ein nukleophiles Amin, das in einer Menge von 1 % bis 50% bezogen auf das Gewicht der Zusammensetzung vorhanden ist,
   c) eine stickstofffreie schwache Säure in einer Menge, die ausreichend ist, das nukleophile Amin zum Teil zu neutralisieren, so dass die Zusammensetzung, wenn sie mit 10 Teilen Wasser verdünnt wird, einen wässrigen pH von 9,6 bis 10,9 hat, wobei die schwache Säure in wässriger Lösung einen pK-Wert von 2,0 oder größer und eine Äquivalentmasse von weniger als 140 hat, und
   d) das Lösungsmittel ein Stripplösungsmittelsystem ist, das einen Löslichkeitsparameter von 8 bis 15 hat und in einer Menge von 50% bis 98% bezogen auf das Gewicht der Zusammensetzung vorhanden ist.

9. Zusammensetzung nach Anspruch 8, wobei die schwache Säure in der Zusammensetzung in einer Menge von 0,05% bis 25% bezogen auf das Gewicht der Strippzusammensetzung vorhanden ist.

10. Zusammensetzung nach Anspruch 9, wobei die schwache Säure einen pK von 2,5 oder höher hat.

11. Zusammensetzung nach Anspruch 10, wobei die schwache Säure 1,2-Dihydroxybenzol ist.

12. Zusammensetzung nach Anspruch 11, wobei das nukleophile Amin 2-Aminoethanol ist.

13. Zusammensetzung nach Anspruch 12, wobei das Lösungsmittelsystem N-Methyl-2-pyrrolidinon und Tetrahydrothiophen-1,1-dioxid und gegebenenfalls bis zu 10% Wasser umfasst.

**14.** Zusammensetzung nach Anspruch 8, umfassend, auf Gewichtsbasis, 50% bis 98% N-Methyl-2-pyrrolidinon, 1% bis 20% Tetrahydrothiophen-1,1-dioxid, 1% bis 20% Wasser, 1% bis 50% 2-Aminoethanol, 0,05% bis 25% 1,2-Dihydroxybenzol und 0,01 % bis 5% CYDTA.

## Revendications

**1.** Procédé d'inhibition de l'adsorption de sodium sur des surfaces de circuit intégré au cours du retrait d'une résine photosensible ou d'un nettoyage après gravage de métal avec une composition contenant un solvant organique, comprenant la mise en contact de la surface avec une composition contenant un solvant organique, comprenant :

a) de l'acide 1,2-cyclohexanediamine tétraacétique (CYDTA),
b) une amine nucléophile présente en une quantité allant de 1 à 50 % en poids de la composition,
c) un acide faible ne contenant pas d'azote en une quantité suffisante pour neutraliser partiellement l'amine nucléophile de sorte que la composition présente un pH aqueux, une fois diluée avec 10 parties d'eau, de 9,6 à 10,9, ledit acide faible ayant une valeur pK dans une solution aqueuse de 2,0 ou plus et un poids équivalent inférieur à 140, et
d) le solvant est un système de solvant d'épuisement ayant un paramètre de solubilité de 8 à 15, et est présent en une quantité de 50 % à 98 % en poids de la composition.

**2.** Procédé selon la revendication 1, dans lequel l'acide faible est présent dans la composition en une quantité de 0,05 % à 25 % en poids de ladite composition d'épuisement.

**3.** Procédé selon la revendication 2, dans lequel l'acide faible a un pK de 2,5 ou plus.

**4.** Procédé selon la revendication 3, dans lequel l'acide faible est le 1,2-dihydroxybenzène.

**5.** Procédé selon la revendication 4, dans lequel l'amine nucléophile est le 2-aminoéthanol.

**6.** Procédé selon la revendication 5, dans lequel le système de solvant comprend de la N-méthyl-2-pyrrolidinone et du 1,1-dioxyde de tétrahydrothiophène et éventuellement jusqu'à 10 % d'eau.

**7.** Procédé selon la revendication 1, comprenant, en poids, de 50 % à 98 % de N-méthyl-2-pyrrolidinone, de 1 à 20 % de 1,1-bioxyde de tétrahydrothiophène, d'environ 1 à 20 % d'eau, de 1 à 50 % de 2-aminoéthanol, de 0,05 % à 25 % de 1,2-dihydroxybenzène et de 0,01 % à 5 % de CYDTA.

**8.** Composition pour inhiber l'adsorption de sodium sur des surfaces de circuit intégré au cours du retrait d'une résine photosensible ou d'un nettoyage après gravage de métal avec une composition contenant un solvant organique, ladite composition contenant un solvant organique comprenant:

a) du CYDTA,
b) une amine nucléophile présente en une quantité allant de 1 à 50 % en poids de la composition,
c) un acide faible ne contenant pas d'azote en une quantité suffisante pour neutraliser partiellement l'amine nucléophile de sorte que la composition présente un pH aqueux, une fois diluée avec 10 parties d'eau, de 9,6 à 10,9, ledit acide faible ayant une valeur pK dans une solution aqueuse de 2,0 ou plus et un poids équivalent inférieur à 140, et
d) le solvant est un système de solvant d'épuisement ayant un paramètre de solubilité de 8 à 15, et est présent en une quantité de 50 % à 98 % en poids de la composition.

**9.** Composition selon la revendication 8, dans laquelle l'acide faible est présent dans la composition en une quantité de 0,05 % à 25 % en poids de ladite composition d'épuisement.

**10.** Composition selon la revendication 9, dans laquelle l'acide faible a un pK de 2,5 ou plus.

**11.** Composition selon la revendication 10, dans laquelle l'acide faible est le 1,2-dihydroxybenzène.

**12.** Composition selon la revendication 11, dans laquelle l'amine nucléophile est le 2-aminoéthanol.

**13.** Composition selon la revendication 12, dans laquelle le système de solvant comprend de la N-méthyl-2-pyrrolidinone et du 1,1-bioxyde de tétrahydrothiophène et éventuellement jusqu'à 10 % d'eau.

**14.** Composition selon la revendication 8, comprenant, en poids, de 50 % à 98 % de N-méthyl-2-pyrrolidinone, de 1 à 20 % de 1,1-bioxyde de tétrahydrothiophène, de 1 à 20 % d'eau, de 1 à 50 % de 2-aminoéthanol, de 0,05 % à 25 % de 1,2-dihydroxybenzène et de 0,01 % à 5 % de CYDTA.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5417802 A
- JP 10171130 A
- WO 9960448 A